(19) Europäisches Patentamt
European Patent Office
Office européen des brevets

(11) **EP 2 417 467 B1**

(12) **EUROPEAN PATENT SPECIFICATION**

(45) Date of publication and mention
of the grant of the patent:
**20.03.2013 Bulletin 2013/12**

(51) Int Cl.:
***G01R 31/02*** *(2006.01)* ***G01R 31/08*** *(2006.01)*

(21) Application number: **09779496.0**

(22) Date of filing: **15.05.2009**

(86) International application number:
**PCT/EP2009/055954**

(87) International publication number:
**WO 2010/115474 (14.10.2010 Gazette 2010/41)**

(54) **Method and system for transient and intermittent earth fault detection and direction determination in a three-phase medium voltage electric power distribution system**

Verfahren und System zur Detektion von Transienten- und in Abständen auftretenden Erdfehlern und Richtungsbestimmung in einem elektrischen Dreiphasen-Mittelspannungs-Energieverteilungssystem

Procédé et système pour la détection des défauts à la terre transitoires et intermittents et la détermination de la direction dans un système de distribution d'énergie électrique triphasé à tension moyenne

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **10.04.2009 CN 200910131630**

(43) Date of publication of application:
**15.02.2012 Bulletin 2012/07**

(73) Proprietors:
• **ALSTOM Technology Ltd**
**5400 Baden (CH)**
• **Tsinghua University**
**Beijing 100084 (CN)**
• **SCHNEIDER ELECTRIC ENERGY UK Ltd**
**Leeds,**
**LS1 5AB (GB)**

(72) Inventors:
• **DONG, Xinzhou**
**Beijing 100084 (CN)**

• **CUI, Tao**
**Beijing 100084 (CN)**
• **BO, Zhiqian**
**BA2 4QD (GB)**
• **KLIMEK, Andrzej**
**Surrey**
**British Columbia BC VS3 7W8 (CA)**
• **JUSZCZYK, Andrzej**
**PL-58-300 Walbrzych (PL)**

(74) Representative: **Ilgart, Jean-Christophe**
**Brevalex**
**95, rue d'Amsterdam**
**75378 Paris Cedex 8 (FR)**

(56) References cited:
**EP-A1- 0 267 500 EP-A1- 1 526 621**
**EP-A2- 0 999 633 EP-A2- 1 195 874**
**WO-A1-99/12048 WO-A1-2004/079378**
**US-A- 5 512 832**

**Description**

**BACKGROUND OF THE INVENTION**

**1. Field of the invention**

This invention relates to a method and a system for transient and intermittent earth fault detection and direction determination in a three-phase median voltage electric power distribution system.

**2. Description of the related art**

The technical field is power system protection and control. The invention is related to the detection of transient/intermittent single phase to ground faults and determination of the earth faults directions in a three-phase median voltage (10 kV-35 kV) electric power distribution system. A transient event refers to a disturbance that only lasts for a short time within one power cycle or several power cycles. An intermittent event refers to a series of transient events, which is a typical feature of arcing fault and high impedance fault in relative short time duration (several seconds).

Conventional detection methods are mainly based on phasor and Fourier results. Therefore, these methods are actually targeting at steady sinusoid signals. However said results may be inaccurate, even incorrect if the event lasts for less than half a cycle. In fact, there are abundant transient information that could be used for fault detection, but the Fourier transform actually filters out these high frequency components. Therefore, conventional phasor based methods are not suitable in dealing with transient and non-steady sinusoid signals.

The document referenced [1] at the end of the description describes a system and a method for detecting high-impedance faults in a multi-grounded power distribution system. The fault evaluation is based on a so-called "Sum of Difference current" (SDI) value which is the sum of the cycle to cycle differences of sampled points. Said method, using non-phasor value to detect such fault generated noises, is a simple sum of the increments, with no other usage of the transient information. It may be vulnerable to other noises. Moreover, it has no direction feature.

The document referenced [2] describes a method and an apparatus which are provided for detecting a fault on a power line carrying a line parameter such as a load current. The apparatus monitors and analyzes the load current to obtain an energy value, which is compared to a threshold value. If the energy value is greater than the threshold value a first counter is incremented. If the energy value is greater than a high value threshold or less than a low value threshold then a second counter is incremented. If the difference between two subsequent energy values is greater than a constant then a third counter is incremented. A fault signal is issued if the first counter is greater than a counter limit value and either the second counter is greater than a second limit value or the third counter is greater than a third limit value. Said document focuses on the randomly changes of the amplitude. The direction of an intermittent fault (or selectively alarming the faulted line) is not a necessary concern. Therefore, it is not applicable to a system with a grounding condition other than a solid grounding.

The document referenced [3] describes a method and an apparatus for identification of an intermittent earth fault in an electric distribution network. The intermittent earth fault is identified on the basis of a zero sequence voltage and a sum current of phase currents. The zero sequence voltage and the sum current are filtered so that the filtered zero sequence voltage and the sum current only comprise a transient component appearing in the intermittent earth fault. When the amplitudes of the transient components of said zero sequence voltage and sum current exceed corresponding set values for the amplitude, and when the phase difference between the phase angles of the transient components of said zero sequence voltage and sum current is within a preset value range, the intermittent earth fault is identified as occuring on the observed electricity distribution feeder. Said document bases its principle on the sinusoid signal information, in seeing the phasor feature from the 500Hz high frequency component. However, to only consider the specified high frequency component often proves to be inaccurate due to the interferences generated by other noises or due to the sampling errors. Also the phase result is often not so stable, the phasor concept is not suitable for the transient scenario.

The document referenced [4] describes a method and a system for protecting an electricity network against restriking earth faults. Said electricity network comprises one or more feeders going out from a supply point and is preferably a three-phase network. The method comprises the steps of detecting an earth contact related to an earth fault in the electricity network, identifying the feeder on which the earth contact occurs by means of current pulses or current pulses and voltage values related to the earth contact. A current value is interpreted as a current pulse at the moment the instantaneous value of the current divided by the effective value of the current exceeds a predetermined limit. The number of detected earth contacts is calculated per each feeder. It is identified that there is a restriking earth fault on the feeder if the number of the detected earth contacts per said feeder exceeds a predetermined number during a predetermined period, or if the number of the detected earth contacts per said feeder exceeds a predetermined number while the voltage between the start point of the electricity network and the earth, i.e. the zero voltage, remains above a predetermined limit. Said document selects the faulty feeder by comparing the polarity of current spikes to the polarity of voltage spikes.

Generally speaking, there are largely existing earth fault phenomena that fall below the reliable detectable level of conventional relays for the protection of distribution feeders. These faults are generally defined within the range of high impedance faults. They are mostly caused by non-metallic or non-steady conducting of the phase to ground fault path: a downed conductor on non-conductive surface, or the intermittently breakdown of poor insulation condition. Therefore, either the impedance in a fault circuit restricts the fault current below the threshold of a fault detector, or the transient conducting restricts the time duration of the fault event and makes the fault undetectable by the conventional protection device. Although these faults may not cause a severe damage to the system, they reveal the defects of the feeders: an intermittent conducting of a transient fault may be a sign of the degradation of the insulation condition along the lines or cables. High impedance fault (HIF) detection is a relatively very active research field. New technologies such as Artificial Intelligent, modern digital signal processing and pattern recognition are all the focuses in the research, however, as a practical improvement for feeder protection, this invention targets at the most distinctive features of HIF and provide a practical algorithm and embodiment that can be easily implemented into a conventional digital feeder relay platform.

Therefore, the invention is focused on such intermittent faults detection or generally on detection of a large catalogue of high impedance faults. So the purpose of the invention method and system is to solve the following problems :

- Transient/intermittent earth fault hides below the reliable detectable level of conventional relays, in revealing the defects of a line that should be detected and alarmed for safety and security reasons, making it necessary to increase the sensitivity.
- In radially connected distribution system, transient earth fault current also flows on healthy lines due to large distributed line capacitance. Direction method is needed to discriminate the faulty lines from healthy lines. The relay's selectivity needs to be increased.
- Conventional phasor based method is not applicable to transient signal computation. Therefore, it cannot give an accurate result when used for direction detection. An accurate direction is an important aspect with respect to security and sensitivity.
- Conventional relay is mostly reset in these transient/intermittent situations. Therefore, it ignores these largely existing earth fault phenomena, which should be included in the detection range of the invention method and system.

## SUMMARY OF THE INVENTION

The invention concerns a method for transient and intermittent earth fault detection and direction determination in a three-phase median voltage electric power distribution system which comprises many lines, according to claim 1.

Advantageously, the instantaneous active or reactive power is used for direction detection.

Advantageously, fault components of residual current and residual voltage are used to calculate the instantaneous power. The Hilbert transform based on instantaneous power is used, the instantaneous active power is obtained by averaging instant residual voltage and residual current's scalar multiplication in previous one cycle time window, while the instantaneous reactive power is obtained by averaging Hilbert transformed instant residual voltage's and residual current's scalar multiplication in previous one cycle time window, the direction discrimination being performed by comparing such instantaneous active power or such instantaneous reactive power to a power threshold.

Advantageously, the method keeps sampling and buffering the samples of the residual current and residual voltage in the normal running stage (READY stage), and these normal samples will be kept in fault evaluation stage (START stage), the fault component being obtained by substracting these normal samples from the full samples in START stage, and the fault components being used for instantaneous power calculation and further direction detection.

Advantageously, in the fault component circuit, assuming the direction from the bus-bar to the feeder is the positive/forward direction, a power threshold is predetermined. If the active instantaneous power is negative and falls below the negative value of power threshold, a forward direction is then issued. If the active instantaneous power is positive and is greater than the positive value of active power threshold, a reverse direction is then issued. If the reactive instantaneous power is positive and greater than the positive reactive power threshold, a forward direction result is then issued. If the reactive instantaneous power is negative and below the negative value of the reactive power threshold then a reverse direction result is issued. Additionally, the instantaneous reactive power is used in neutral point isolated or resistor grounded system, while the instantaneous active power is only used in neutral point Peterson coil grounded system.

Advantageously, the method comprises a fault evaluation step, wherein the direction is given by comparing the calculated instantaneous power with a power threshold, the power threshold being adaptively changing according to the maximum value of the calculated power. The power threshold may be set to a half of the maximum calculated power absolute value: If the instantaneous power value is such that its absolute value is five times greater than the P (Active Power) or Q (Reactive Power)'s current thresholds, half of the greatest instantaneous power absolute value is considered as the new threshold.

Advantageously incremental amplitude is used to detect intermittent spikes, and to initiate fault evaluation, the amplitude being computed by using half-cycle R.M.S. calculation, a spike being a consecutive increase and decrease of residual current incremental amplitude which indicates conducting and extinguishing of a spike. The spike's direction is obtained from transient direction detection step, when fault evaluation is initiated, within a settable detection time, said spikes with forward direction being counted, the results at the end of the fault evaluation time being used to compare to specified thresholds and to subsequently give out a set of fault detection results. Incremental amplitude is obtained by subtracting the average amplitude from the newly calculated amplitude, the average amplitude being obtained by a filter: $y(n)= [y(n-1) \cdot (N-1) + x(n) ] /N$, where $y(n)$ is the average amplitude on a current time point, and represents previous N points amplitude conditions, $y(n-1)$ is the average amplitude of the previous point, $x(n)$ is the newly calculated amplitude. At the end of fault evaluation, if the numbers of spikes counted exceeds a determined level, the result indicates an intermittent fault ; if the number of spikes is more than 2 but is below the determined level, a transient event is reported ; if the amplitude keeps increasing or remains unchanged without decrease, a steady event is the result ; other situations being reported as noises.

The invention also concerns a system for transient and intermittent earth fault detection and direction determination in a three-phase median voltage electric power distribution system which comprises many lines, according to claim 19.

Advantageously, said system comprises :

- a module for sampling voltage and current,
- a trigger,
- an intermittent spike detection module,
- a module for adjusting a power threshold of transient direction detection,
- an instantaneous power direction module,
- a counter,
- a module giving out a report.

The invention method and system are using instantaneous power direction that is applicable to non-sinusoid signals. The invention is actually utilizing high frequency components. It can also be implemented at power frequency sampling rate and can be easily integrated into conventional protection devices. Thus, the advantages are:

- The instantaneous power is suitable for analyzing the non-sinusoid transient signals.
- The instantaneous power can be obtained in a relative lower sampling rate so that the invention method is convenient to be used in conventional digital relay platforms.
- The instantaneous reactive power is especially effective when used in a resistor grounded system or isolated system. Said power is only related with system characteristics, therefore it is more robust. The proposed adaptive threshold enables the direction detector to give a definite direction result when a spike has been captured.
- Based on the instantaneous power direction, the invention provides a more reliable solution for an isolated or resistor grounded system by using instant reactive power, and a possible solution for Peterson coil grounded system by using instant active power.
- The invention makes it possible to respond to transient and intermittent faults, also regarded as high impedance faults or arcing faults, that conventional relays fail to deal with.
- The invention makes it possible to selectively alarm on faulty lines.
- The invention is applicable in uni-grounded system with different grounding conditions : resistor grounded, Peterson coil grounded or isolated.

**BRIEF DESCRIPTION OF THE DRAWINGS**

Fig. 1 shows the configuration of the invention system.
Fig. 2 is the diagram, in the invention system and method organization, of transient direction detection (TDD) and random intermittent detection (RID).
Fig. 3 is the flowchart of transient direction detection.
Fig. 4A and 4B show the invention direction criteria using instantaneous power.
Fig. 5 is an example of the adaptive threshold setting of transient direction detection.
Fig. 6 is the flowchart of random intermittent detection.

Fig. 7A-7C and 8A-8C show exemplary results for a preferred implementation of integration of random intermittent detection and transient direction detection.

## DESCRIPTION OF THE PREFERRED EMBODIMENTS

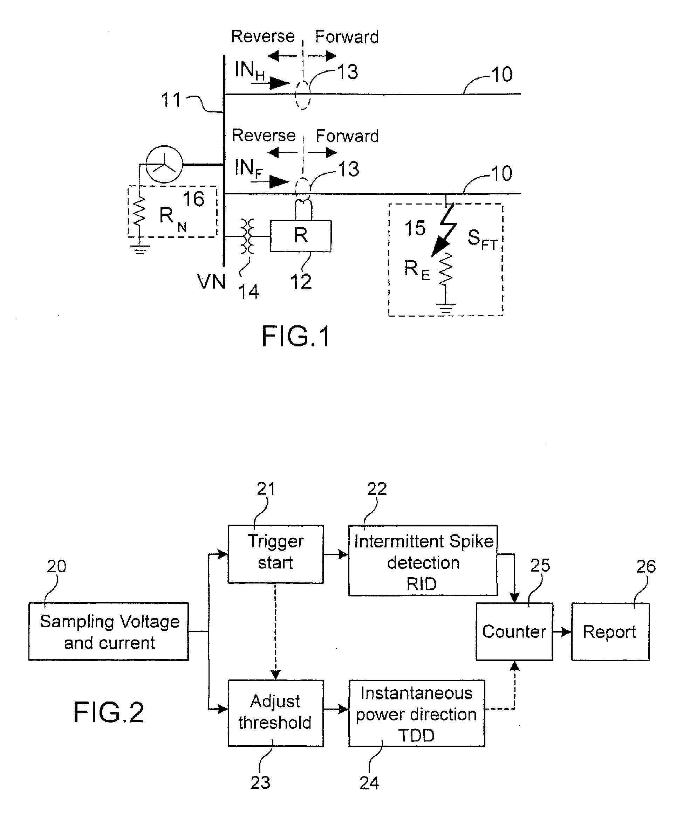

As shown in Fig. 1 the invention system is applicable to detect transient/intermittent single phase to ground faults in a three-phase three-wire median voltage (10 kV - 35kV) electric power distribution system. To selectively alarm on the faulty feeder among all feeders 10 which are radially connected on a bus-bar 11, the neutral point of the system is ungrounded or is grounded at only one point 16, which is often in a substation via a transform. The detecting device 12, which is normally installed in the substation where the bus bar is installed, samples the residual current from CT (Current Transformer) 13 on one feeder and residual voltage from PT (Potential Transformer) 14 on busbar. It detects the transient grounding fault event 15 and identifys the direction of such event. The direction results are forward direction (from busbar to feeder) and reverse direction (from feeder to busbar). When the fault is on the feeder where the detector has been installed, a forward direction should be seen by the detector, while the fault is on the other feeders, a reverse direction or non-direction should seen by the detector. The detector alarms when an intermittent event (series of transient grounding events) with forward direction has been detected, indicating the substation personnel to check the status of the feeder where this alarmed detector has been installed.

The invention system is designed to directionally detect earth faults, especially the transient/intermittent ones which also cover a large portion of high impedance single phase to ground faults. It overcomes the difficulties that the conventional relays cannot rightly deal with the intermittent and transient events, and cannot rightly respond to said events. Therefore, it can be an improvement or a supplement for a conventional earth fault detection device.

The method and system of the invention have two main modules :

1) For a transient direction detection, it calculates the instantaneous power direction based on fault component residual current and fault component residual voltage. Indeed, in the fault component circuit, the active power flows from the bus-bar to the healthy line, and flows from the faulty line to the bus-bar. If the electric power distribution system is grounded via a resistor or is not grounded, the reactive power flows from the bus-bar to the faulty line and flows from the healthy line to the bus-bar. Therefore, a threshold of corresponding power component is set, and by comparing the calculated instantaneous power to the threshold, the algorithm gives out a direction result. Said active power and reactive power are obtained by using Hilbert transform based on instantaneous power for non-sinusoid signals. The advantage of using such instantaneous power direction enables the algorithm to output a valid direction result even for a fast transient event. As the instantaneous reactive power direction is mainly depending on the system characteristics (inductive or capacitive), making it a more robust feature, therefore the selectivity as well as the sensitivity can be increased.

2) For a random intermittent detection, it accumulates an average amplitude value in a pre-fault READY stage and calculates the incremental amplitude by subtracting the average amplitude from the full amplitude. At the beginning, the incremental amplitude is compared to a start threshold and triggers the module into START stage. Then, the detecting device begins by counting the changes of the amplitude status, which is the changes of status being *above* or *below* another burst threshold. Also if the direction module is enabled, the detecting device counts the changes with a specified direction. At the end of the preset detection time, the algorithm gives out a report according to the counting result. This increases the chances for the detecting device to capture those widely existing earth fault phenomena that conventional relay may not be able to respond to.

Advantageously, the invention system, as shown on figure 2, comprises :

- a module 20 for sampling voltage and current,
- a trigger 21,
- an intermittent spike detection module 22,
- a module 23 for adjusting a power threshold of transient direction detection,
- an instantaneous power direction module 24,
- a counter 25,
- a module 26 giving out a report.

The invention method includes a transient direction detection (TDD) step and a random intermittent detection (RID) step. Both have three major stagers :

- a READY stage, when the algorithm keeps monitoring ready to be started;
- a START stage when the algorithm begins to evaluate the fault; and

- an ALARM/RESET stage, when the START stage ends, the algorithm gives out the result by alarm (fault confirmed) or reset (fault not confirmed). These two detection steps are analyzed below.

1) Transient Direction Detection (TDD)

The transient direction detection (TDD) has a pre-start buffer for updating two-cycle samples array of the residual current and residual voltage when the algorithm is in READY stage. Transient direction detection is started by trigger 21 by capturing the residual current's abrupt increase. When in START stage, transient direction detection firstly calculates the superimposed residual current and residual voltage by subtracting the points in the pre-start buffer of the second cycle in READY stage samples from the newly sampled residual current and residual voltage on the corresponding point. By using such superimposed current i(t) and voltage u(t), the transient direction detection calculates the instantaneous power :

- For the active power, the instantaneous value is :

$$p(t) = u(t) \cdot i(t)$$

The instantaneous active power is the average value of p(t) in previous one cycle T:

$$P = \frac{1}{T} \int_{t-T}^{t} p(t) \cdot dt$$

- For the reactive power, the Hilbert transform is applied. the Hilbert transform by convolution is defined by the following function, p.v. representing Cauchy primary value :

$$h(t) = p.v. \frac{1}{\pi t}$$

Transient direction detection calculates :

• The Hilbert transform of the residual voltage, convolution using Cauchy Primary Value Integral :

$$u'(t) = H(u)(t) = p.v. \int_{-\infty}^{+\infty} u(\tau) h(t - \tau) d\tau$$

• Then, the instant value of the power by p' :

$$p'(t) = u'(t) \cdot i(t)$$

The instantaneous reactive power is the average value of p' in one cycle:

$$Q = \frac{1}{T} \int_{t-T}^{t} p'(t) \cdot dt$$

- Then, the direction criterion is, assuming the power direction is positive/forward when it flows from the bus-bar to the feeder :

  a) In a system grounded via a resistor or ungrounded:

- If Q is above the forward Q threshold (a positive value), direction is forward and fault is on this line;
- Otherwise, direction is not on this line.

  b) In a system grounded via a Peterson coil:

- If P is below the forward P threshold (a negative value), direction is forward and fault is on this line;
- Otherwise, direction is not on this line.

2) Random intermittent detection (RID)

The random intermittent detection is based on the changes of the incremental amplitude of the residual current. If the increment of the amplitude is greater than a predetermined threshold, the random intermittent detection assumes the fault is conducted. If said increment is below the threshold the random intermittent detection assumes the fault is extinguished. By counting such conducted-extinguished state changes of forward direction within a preset time duration, the algorithm gives out a set of results for confirmed earth faults, or transient events, steady events and noises.

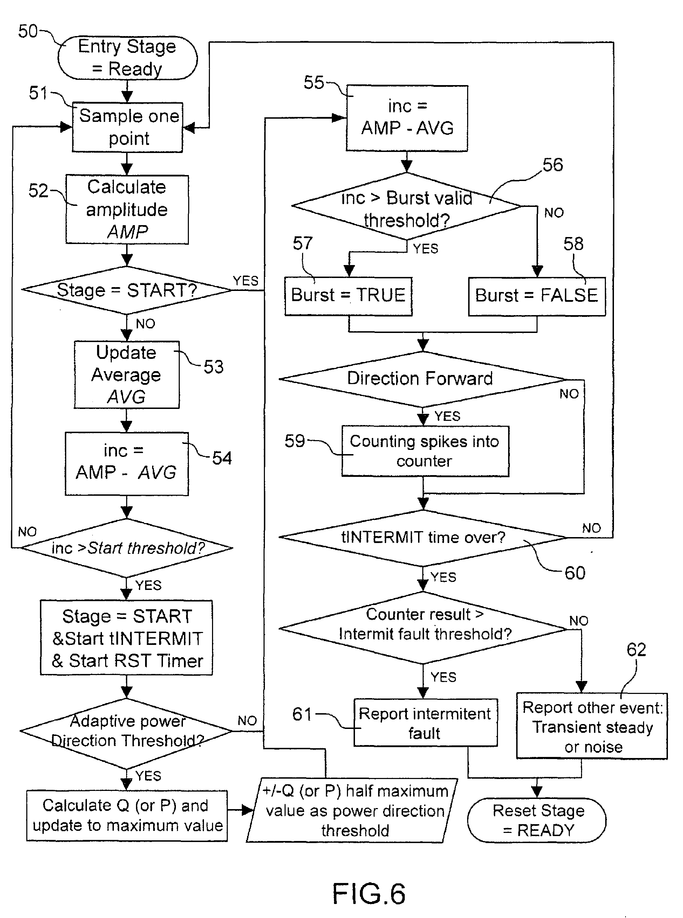

As shown on Fig. 6, in READY stage, the random intermittent detection keeps calculating the amplitude AMP (step 52) by using half-cycle R.M.S. ("Root Mean Square") method. It then uses this value for updating an average amplitude value AVG (step 53) which is stored in a memory as a representation of the current condition of the residual current. By subtracting this average value from the newly calculated amplitude AMP, an increment value "inc" is obtained (step 54). In READY stage, the random intermittent detection compares "inc" to the start threshold to trigger a start signal, this signal is the trigger 21 in Fig.2. In START stage, the average amplitude value AVG stops updating and keeps its latest value in READY stage. While increment "inc" is obtained by subtracting this average amplitude from newly calculated amplitude (step 55), another threshold, a burst threshold, is used for comparison. If the increment "inc" is greater than said burst threshold (step 56), random intermittent detection assumes the fault is conducted and sets the fault conducted status ("burst") to "true" (57). If the incremental amplitude "inc" is lower than said burst threshold (step 56), random intermittent detection assumes the fault is extinguished and sets the fault conducted status ("burst") to "false" (58). Random intermittent detection also keeps sampling the direction result of transient direction detection. A burst counter keeps counting the changes of such status changes of forward direction (step 59). At the end of the START stage (The timer: tINTERMIT times over ; step 60), the result of this counter is then compared to a set of event thresholds. If intensive changes of fault conducted status are present, an intermittent earth fault result is issued (step 61). Otherwise, other results such as transient events (the result of the counter does change but does not exceed fault threshold), steady events (the amplitude only increase and keep above burst threshold) and noises are issued (step 62). In ALARM/RESET stage, the algorithm outputs the result, and discards the average amplitude and starts running all over again.

3) Extending random intermittent detection to address intermittent events

Another global reset timer is set to reset the entire algorithm. If a transient event is detected by random intermittent detection and transient direction detection at the end of the START stage, the algorithm keeps waiting for further events. If consecutive three transient events are detected within such reset time duration, an intermittent earth fault will also be reported.

4) Transient direction detection adaptive threshold setting

A facility algorithm tracks the maximum absolute value of the calculated power by transient direction detection and automatically sets the P or Q thresholds to half of their maximum values. The algorithm is started with random intermittent detection and transient direction detection, and adaptively changes the direction thresholds in 1) to enable the direction algorithm giving out a definite direction result when a transient event has been captured by random intermittent detection, and also to rule out any possible noises and distortion of the transient direction detection.

**A Preferred Embodiment**

In said preferred embodiment, random intermittent detection and transient direction detection are implemented into a sampling and alarming device. Said device keeps sampling the residual current and the residual voltage of a feeder. The residual value can be directly obtained from a transformer for a residual value or can be derived from a phase value. Said device performs the algorithm in real time. It executes the algorithm every half power cycle. Said device is able to track the power frequency and to adjust its sampling rate to exactly N points per cycle (for example N=24 in this device). Moreover, it is able to retrieve the history sample value at every execution point.

*1. Implementation of the Transient Direction Detection (TDD) method*

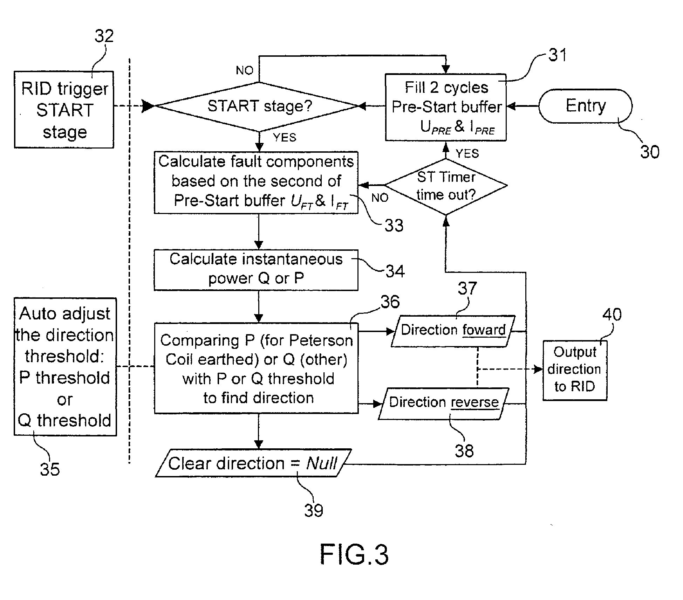

As shown on Fig. 3, after the entry (30), transient direction detection keeps filling a two-cycle length pre-fault buffer (step 31), when it is in READY stage. When random intermittent detection sets the detecting device into START stage (step 32), the transient direction detection moves the second pre-fault cycle into a buffer, and by subtracting this second pre-fault cycle from full sampled current and voltage at every execution point, the fault current and voltage component is obtained (step 33). The fault current and voltage component is the input value of the transient direction detection algorithm. If the detecting device is configured to use the reactive power direction (which is recommended for the system with neutral point grounded via a resistor or isolated) at every half cycle, the Hilbert transform is applied on fault component voltage of the previous two-cycle array. Practically, the Hilbert transform is applied by convolution summation (symbole "*") of the digital Hilbert coefficient with the input sample signals :

$$DHT(x)[n] = h[n] * x[n]$$

where:

$$h[n] = \begin{cases} 0 & \text{n is even} \\ \dfrac{2}{n\pi} & \text{n is odd} \end{cases} \quad -N < n < N$$

With respect to the Hilbert transform, a 48 points buffer stores two cycles of history sample data as the input x[n] array. After the Hilbert transform is applied, the 24 points in the middle of the result array UN are taken as the Hilbert transform result. Two cycles of residual voltage UN are the input signal. Therefore one cycle UN' (in the middle of the convolution result) is the Hilbert transform result. Product of UN' and of residual current IN's corresponding points produces the instant reactive power array q[n]. The average value of q[n] array of one previous cycle (instantaneous reactive power Q) is used to detect the fault direction in a neutral point resistor grounded or isolated system. Product of UN and of residual current IN's corresponding points produces the instant active power array p[n]. The average value of p[n] array in one previous cycle (instantaneous active power P) is used to detect the fault direction in a neutral point Peterson coil grounded system. Therefore instantaneous powers P or Q are calculated (step 34).

Although the direction can be represented by the symbols of the calculated power, a threshold is set to rule out possible noise interferences. In a threshold setting (step 35), a power threshold is set to detect the direction. When using reactive power, if the calculated reactive power Q is greater than the forward +Q threshold (step 36) a forward direction is set (step 37). If the calculated reactive power is less than -Q threshold (step 36), a reverse direction flag is set. When using active power, if the calculated active power P is less than -P threshold a forward direction flag is set. If the calculated active power is above the +P threshold a reverse direction flag is set (step 38). Step 39 shows a clear direction (=Null). Step 40 shows output direction to random intermittent detection (RID).

Said thresholds can be set by two means:

a) Fixed threshold :

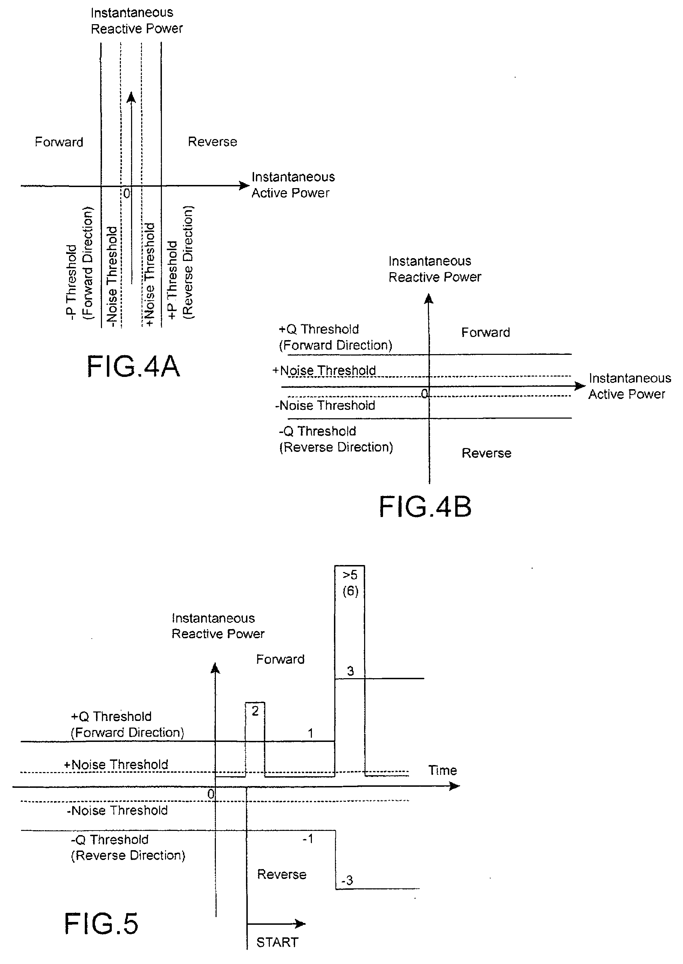

A fixed threshold is a power threshold for direction detection. As shown in Fig 4B, if using reactive power, a Q threshold (for forward direction) is set. If calculated instantaneous reactive power is greater than +Q threshold, a forward direction flag is issued. If the calculated instantaneous reactive power is less than the +Noise threshold, then the forward direction flag is cleared. If the calculated reactive power is negative and below -Q threshold, a reverse direction is set. If the calculated reactive power is greater than -Noise threshold, then a reverse direction flag is cleared. As shown on fig. 4A, if using active power, a P threshold (for reverse direction) is set. If calculated instantaneous active power is greater than +P threshold, a reverse direction flag is set. If calculated instantaneous active power is less than +Noise threshold, the reverse flag is cleared, forward direction is obtained.

b) <u>Adaptive threshold</u> :

An adaptive threshold is adjusting itself according to the amplitude/power conditions. In START stage, when a transient fault conducting state is confirmed by random intermittent detection for the first time, the transient direction detection takes half of the absolute value of the instantaneous power as the threshold (P or Q thresholds). Then if another instantaneous power value is much greater (said absolute value is five times greater than the P or Q thresholds), half of the greatest instantaneous power absolute value is taken as the new threshold. Therefore, in the START stage of the algorithm, transient direction detection seeks the greater value of the instantaneous power within the START time duration and automatically sets the threshold according to the value of this power. This is to ensure that the transient direction detection gives a definite result of direction and also to avoid noise interferences.

Adaptive threshold is recommended to be used with reactive instantaneous power direction detection. An example is show in Fig 5. When in START stage, the instantaneous power of the first transient spike is '2', then Q threshold is set to '1', the second power spike is '6' which is much (five times) greater than the older Q threshold, so the Q threshold is changed to half of it, therefore 3 is the new Q threshold.

2. _Implementation of the Random Intermittent Detection (RID) Method_

As shown on Fig. 6, after entry 50, the random intermittent detection method samples the residual current (step 51) or derives the residual current from phase current. The random intermittent detection is the main algorithm that triggers the detection duration (by triggering the START stage) and gives out the fault detection result. In the READY stage, the random intermittent detection calculates the following values :

1) The average amplitude y(n) of the residual of previous N points, is obtained by a filter :

$$y(n) = [y(n-1) \cdot (N-1) + x(n)]/N$$

where n is the currently sampling/calculating point ; N is the total length that the average value represents ; N is settable, and here N=24x50x10 represents previous 10 seconds history value. y(n) is the current average amplitude on current time point, and represents previous N points amplitude conditions. y(n-1) is the average amplitude of the previous point. x(n) is the newly calculated full amplitude according to the previous half-cycle of the sampled residual current. In normal running stage the filter is applied to update the average condition of the residual amplitude. But in fault evaluation stage, the average amplitude is kept unchanged representing the amplitude condition of the prestart stage.

2) The incremental amplitude "inc(n)" is such that :

$$inc(n) = x(n) - y(n-1).$$

In the READY stage, the random intermittent detection compares "inc(n)" to the start threshold to trigger a start signal and to put random intermittent detection and transient direction detection into the START stage. The amplitude is based on half-cycle Fourier or R.M.S. calculation result. If "inc(n)" exceeds the start threshold, the algorithm enters the START stage. A global reset timer 'RST timer' starts. The duration is 30 seconds. The entire algorithm is reset at the end of RST timer if it is not reset by other means.

In the START stage, the average value as well as the pre-start sample array is kept (stop updating). The incremental amplitude "inc(n)" is obtained by inc(n) = x(n) - y(n-1). But y(n-1) is locked to the latest pre-start value. In the START stage, a burst threshold is set. When the incremental amplitude "inc(n)" is greater than the burst threshold, the fault is assumed to be conducted. Once the residual current is below the burst threshold, the fault is extinguished. A consecutive conducting and extinguishing forms a spike. Random intermittent detection counts such spikes within a preset time duration, which is fixed by a timer called tINTERMIT (to evaluate intermittent events). Said timer is started once the incremental amplitude value "inc(n)" of the residual current is above the burst threshold. When the timer tINTERMIT is timing, a counter begins counting the spikes. At the end of the preset time duration, the value of the counter is compared to a set of threshold. In this example, if within 5 seconds (tINTERMIT duration), up to 10 spikes have been captured by the counter, an intermittent fault is reported. If only several (up to 3) spikes have been captured by the counter, a transient event is reported. If only one or two spikes have been captured, they are ignored as noises. If the incremental amplitude "inc(n)" stays above the burst threshold for the entire preset time duration, a steady event is then reported.

*3. Integration of random intermittent detection and transient direction detection*

The integration of the transient direction detection and random intermittent detection consists of two parts: in the START stage and in the detection result report.

In the START stage, the integration is as shown in Fig 2 : The counter 25 of the random intermittent detection only counts the spikes with forward direction result from the transient direction detection for the fault evaluation, therefore ruling out the interferences of the fault interference on healthy lines.

In the detection result report 26, the detailed implementation is as follows :

- If the result is intermittent fault, then report and alarm and reset entire algorithm.
- If the result is noises or steady event, then ignore, do nothing.
- If the result is transient event, then algorithm continues in the START stage and waits for further event until entire algorithm is reset by RST timer.
- If at the end of RST timer, up to 3 transient events have been spotted, then report as intermittent fault, alarm and reset.

*4. Examples*

The invention has been implemented into MiCOM P145 relay as a prototype model and has been tested by both physical model and digital simulation:

a. It can selectively alarm on a faulty line and restraint on healthy line in case of intermittent fault. The physical system is earthed via a resistor.

b.Positive results have been obtained from digital simulation (EMTP ("Electromagnetic transient program") Test) with various cases including all kinds of grounding conditions. RTDS ("Real True Digital Simulator") simulation has also been planned. The principle of RTDS and EMTP is the same.

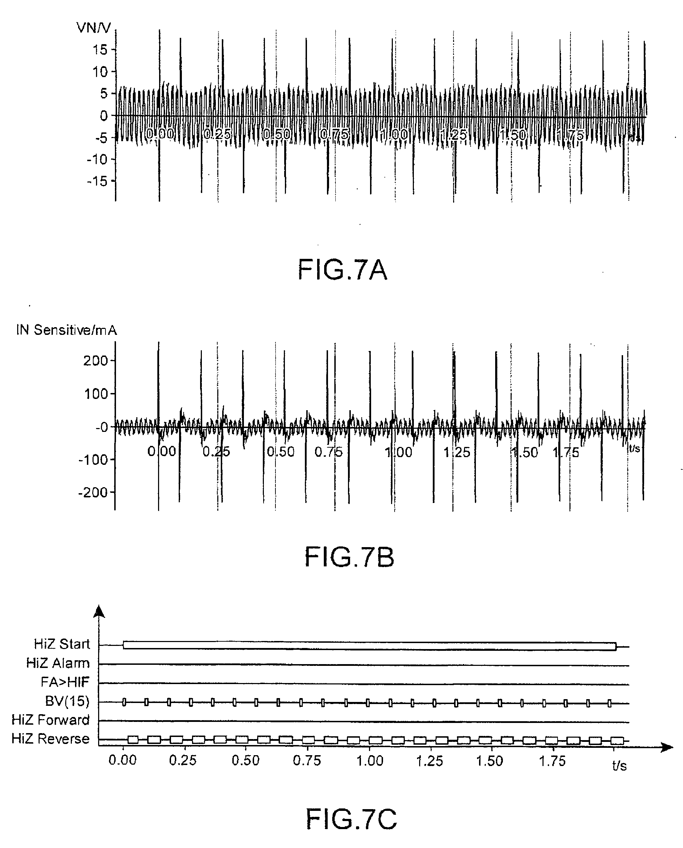

An exemplary result from the physical model is as shown on Fig. 7A, 7B and 7C when the prototype relay is installed on a healthy line. The system is earthed via a resistor to restrict the fault current. An intermittent earth fault also causes intensive disturbance on a healthy line: Fig. 7A shows the sampled residual voltage's waveform labelled with "VN", and Fig. 7B shows residual current's waveform labeled with "IN Sensitive". All sampled value are from the secondary side of the relay, Fig. 7C shows relay's responses. The spikes are identified by comparing amplitude's increment to a threshold and indicated by "BV". The direction result "HiZ_Reverse" and "HiZ_Forward" are obtained by using the instantaneous reactive power's direction. "HiZ Start" indicates the algorithm is in START stage. "HiZ Alarm" is the alarming result. "FA>HIF" means the alarm is triggered by this RID module. The algorithm has been able to selectively count the spikes. Therefore, there is no alarm in this situation because all the spikes are identified in the reverse direction with "HiZ_Reverse".

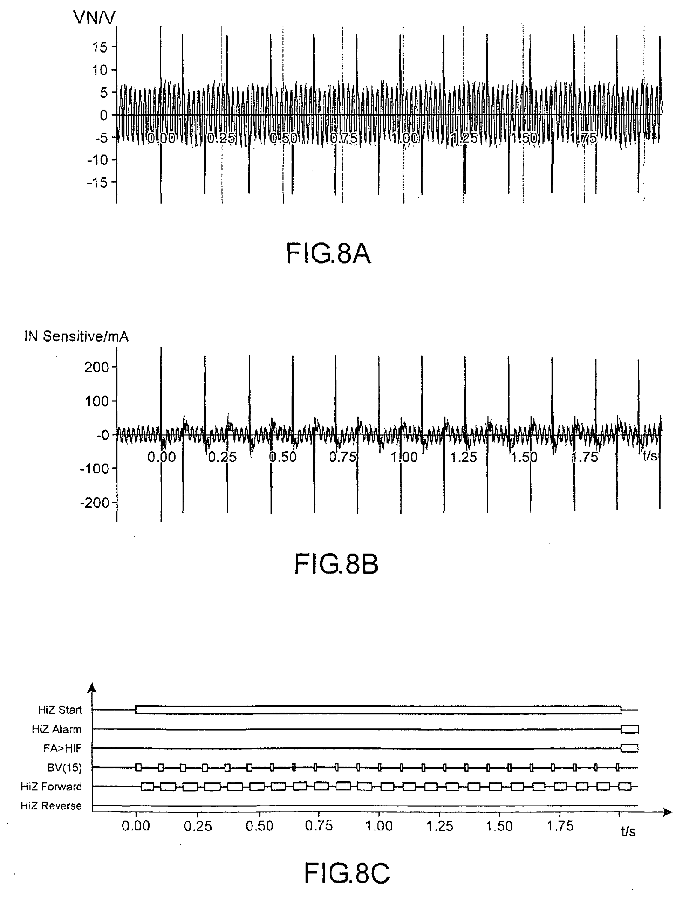

An exemplary result from the physical model is as shown on Fig. 8A, 8B and 8C in the same way as in Fig. 7A, 7B and 7C. The prototype relay is installed on a faulty line. The spikes with forward direction "HiZ_Forward" are counted and then the algorithm alarms on this faulty line due to the number of forward spikes exceeds the threshold.

**References**

[1] US 2008/0031520

[2] US 5 485 093

[3] WO 2005 038474

[4] EP 0 999 633

**Claims**

**1.** A method for transient and intermittent earth fault detection and direction determination in a three-phase median voltage electric power distribution system which comprises many lines, **characterized in that** it comprises, for one line :

- a sampling step wherein the residual current and the residual voltage on said line are sampled, the power frequency is tracked and the sampling rate is adjusted to N points per cycle, N being an integer.
- a transient direction detection step comprising :

  • in a ready stage,
  * updating samples of the residual current and the residual voltage in a buffer,
  • in a start stage,
  * calculating the superimposed residual current and residual voltage by substracting a point in the buffer from the newly corresponding sampled residual current and residual voltage,
  * calculating the instantaneous power direction based on superimposed residual current and residual voltage,
  * giving out a direction result by comparing the calculated instantaneous power to a power threshold,

- a random intermittent detection step comprising :

  • in a ready stage,
  * accumulating an average amplitude value,
  * calculating an incremental amplitude by substracting the average value from the full amplitude,
  • in a start stage,
  * comparing the incremental amplitude to a burst threshold, a fault being assumes to be conducted if the incremental amplitude is greater than the burst threshold,

- a step of integrating transient direction detection and random intermittent detection comprising :

  * counting the number of consecutive conducting and extinguishing, forming spikes, in counting only the spikes with forward direction result from the transient direction detection step for the fault evaluation,
  * comparing the counted value obtained at the end of a preset time to many thresholds so that a result is obtained : it is an intermittent fault, a transient event or a steady event,

- a step of giving out the result by alarm or reset in the following way :

  * if the result is intermittent fault, then report and alarm and reset,
  * if the result is noises or steady event, then ignore, do nothing,
  * if the result is transient event, then continue in the START stage and wait for further event until reset at the end the preset time,
  * if at the end of the preset time, up to three transient events have been spotted, then report as intermittent fault, alarm and reset.

2. The method according to claim 1, wherein the transient direction detection step and the random intermittent detection step have the following stages :

   - a READY stage, when the algorithm keeps monitoring and is ready to be started ;
   - a START stage when the algorithm begins to evaluate the fault ; and
   - an ALARM/RESET stage, occurring when the START stage ends, wherein the result by alarm or reset is given out.

3. The method according to claim 2, wherein if a transient event is detected by random intermittent detection and transient direction detection at the end of the START stage, further events are expected, and if consecutive three transient events are detected within a reset time duration, an intermittent earth fault is reported.

4. The method according to claim 1, wherein the instantaneous active or reactive power is used for direction detection.

5. The method according to claim 1, wherein fault components of residual current and residual voltage are used to calculate the instantaneous power.

6. The method according to claim 5, wherein the Hilbert transform based instantaneous power is used.

7. The method according to claim 6, wherein the instantaneous active power is obtained by averaging instant residual voltage and residual current's scalar multiplication in previous one cycle time window, while the instantaneous reactive power is obtained by averaging Hilbert transformed instant residual voltage's and residual current's scalar multiplication in previous one cycle time window, the direction discrimination being performed by comparing such instantaneous active power or such instantaneous reactive power to a power threshold.

8. the method according to claim 5, which keeps sampling and buffering the samples of the residual current and residual voltage in the normal running stage (READY stage), and these normal samples will be kept in fault evaluation stage (START stage), the fault component being obtained by substracting these normal samples from the full samples in START stage and the fault components being used for instantaneous power calculation and further direction detection.

9. The method according to claim 5, wherein, in the fault component circuit, assuming the direction from the bus-bar to the feeder is the positive/forward direction, a power threshold is predetermined.

10. The method according to claim 9, wherein, if the active instantaneous power is negative and falls below the negative value of a power threshold, a forward direction is then issued, if the active instantaneous power is positive and is greater than the positive value of active power threshold, a reverse direction is then issued.

11. The method according to claim 9, wherein, if the reactive instantaneous power is positive and greater than the positive reactive power threshold a forward direction result is then issued ; if the reactive instantaneous power is negative and below the negative value of the reactive power threshold then a reverse direction result is issued.

12. The method according to claim 9, comprising a fault evaluation step, wherein the direction is given by comparing the calculated instantaneous power with a power threshold, the power threshold being adaptively changing according to the maximum value of the calculated power.

13. The method according to claim 12, wherein the power threshold is set to half of the maximum calculated power absolute value.

14. The method according to claim 13, wherein if the instantaneous power value is such than its absolute value is five times greater than the active power or reactive power present thresholds, half of the greatest instantaneous power absolute value is considered as the new threshold.

15. The method according to claim 1, wherein incremental amplitude is used to detect intermittent spikes, and to initiate fault evaluation, the amplitude being computed by using half-cycle R.M.S. calculation.

16. The method according to claim 15, wherein the spike's direction is obtained from transient direction detection step, when fault evaluation is initiated within a settable detection time, said spikes with forward direction being counted, the results at the end of the fault evaluation time being used to compare to specified thresholds.

17. The method according to claim 15, wherein incremental amplitude is obtained by subtracting the average amplitude from the newly calculated amplitude, the average amplitude being obtained by a filter: $y(n) = [y(n-1) \cdot (N-1) + x(n)]/N$, where $y(n)$ is the average amplitude on a current time point, and represents previous N points amplitude conditions, $y(n-1)$ is the average amplitude of the previous point, $x(n)$ is the newly calculated amplitude.

18. The method according to claim 15, wherein, at the end of fault evaluation, if the numbers of spikes counted exceeds a determined level, the result indicates an intermittent fault ; if the number of spikes is more than 2 but is below the determined level, a transient event is reported ; if the amplitude keeps increasing or remain unchanged without decrease, a steady event is the result ; other situations being reported as noises.

19. A system for transient and intermittent earth fault detection and direction determination in a three-phase median voltage electric power distribution system which comprises many lines, **characterized in that** it comprises :

- sampling means (20) adapted to sample residual current and residual voltage on one of said lines, to track the power frequency and to adjust the sampling rate to exactly N points per cycle, N being an integer,

EP 2 417 467 B1

- transient direction detection means (24), which implement :

• in a ready stage,
* updating samples of the residual current and the residual voltage in a buffer,
• in a start stage,
* calculating the superimposed residual current and residual voltage by substracting a point in the buffer from the newly corresponding sampled residual current and residual voltage,
* calculating the instantaneous power direction based on superimposed residual current and residual voltage,
* giving out a direction result by comparing the calculated instantaneous power to a power threshold,

- random intermittent detection means (22), which implement :

• in a ready stage,
* accumulating an average amplitude value,
* calculating an incremental amplitude by substracting the average value from the full amplitude,
• in a start stage,
* comparing the incremental amplitude to a burst threshold, a fault being assumed to be conducted if the incremental amplitude is greater than the burst threshold,

- means of integrating transient direction detection and random intermittent detection, which implement :

* starting a counter (25) and counting the number of consecutive conducting and extinguishing, forming spikes, in counting only the spikes with forward direction result from the transient direction detection means,
* comparing the counter's value obtained at the end of a preset time to many thresholds so that a result is obtained : it is an intermittent fault, a transient event or a steady event,

- means (26) of giving out the result by alarm or reset which implement :

* if the result is intermittent fault, then report and alarm and reset,
* if the result is noises or steady event, then ignore, do nothing,
* if the result is transient event, then continue in the START stage and wait for further event until reset by a preset timer,
* if at the end of the preset time, up to three transient events have been spotted, then report as intermittent fault, alarm and reset.

20. The system according to claim 19, which comprises :

- a module (20) for sampling voltage and current,
- a trigger (21),
- an intermittent spike detection module (22),
- a module (23) for adjusting a power threshold of transient direction detection,
- an instantaneous power direction module (24),
- a counter (25),
- a module (26) giving out a report.

**Patentansprüche**

1. Verfahren zur transienten und intermittierenden Erdfehlererfassung und Richtungsbestimmung in einem elektrischen Dreiphasen-Mittelspannungs-Leistungs-Verteilungssystem, das viele Leitungen aufweist, **gekennzeichnet durch** die folgenden Schritte, und zwar für eine Leitung: ein Abtastschritt, bei dem der Reststrom und die Restspannung in dieser Leitung abgetastet werden, die Leistungsfrequenz abgezogen wird und die Abtastrate auf N Punkte pro Zyklus eingestellt wird, wobei N eine ganze Zahl ist; einen Übergangsrichtung-Erfassungsschritt, umfassend in einem einsatzbereitem Zustand das Aktualisieren von Abtastwerten des Reststroms und der Restspannung in einem Puffer, in einem Startzustand das Berechnen des überlagerten Reststroms und der Restspannung **durch** Subtraktion eines Punktes in dem Puffer von dem neuerlich korrespondierenden, abgetasteten Reststrom und der Restspannung, ferner das Berechnen der augenblicklichen Stromrichtung auf der Grundlage des überlagerten Reststroms

13

und der Restspannung, sowie das Ausgeben eines Richtungsresultats **durch** Vergleichen des berechneten augenblicklichen Stroms mit einem Stromschwellenwert, des weiteren einen zufälligen, intermittierenden Erfassungsschritt, umfassend in einem einsatzbereiten Zustand das Speichern eines zuständlichen Amplitudenwertes, das Berechnen der inkrementalen Amplitude **durch** Subtraktion des Durchschnittswertes von der vollen Amplitude; in einem Startzustand das Vergleichen der inkrementalen Amplitude mit einem gesprengten Schwellenwert, wobei ein Fehler angenommen wird, der abzuziehen ist, wenn die inkrementale Amplitude größer ist als der gesprengte Schwellenwert; des weiteren bestehend aus einem Schritt der Integration der Übergangsrichtungs-Bestimmung und der zufälligen intermittierenden Bestimmung, umfassend Zählen der Anzahl aufeinanderfolgender leitender und auslöschender, formender Spitzen, wobei nur die Spitzen in Vorwärtsrichtung gezählt werden, die sich aus dem transienten Richtungsermittlungsschritt für die Fehlerbewertung ergeben, Vergleichen des an dem Ende einer vorbestimmten Zeit erhaltenen Zählwertes mit vielen Schwellenwerten, so daß ein Ergebnis erhalten wird, dies ist ein intermittierender Fehler, ein Übergangsereignis oder ein stetiges Ereignis; woraufhin die Ausgabe des Ergebnisses sowie Alarm oder Zurückstellung auf die folgende Weise erfolgen: Wenn das Ergebnis ein intermittierender Fehler ist, dann erfolgt Bericht und Alarm und Zurückstellung, wenn das Ergebnis Geräusche sind oder ein stetiges Ereignis, dann wird dies nicht zur Kenntnis genommen und nichts getan, wenn das Ergebnis ein transientes Ereignis ist, dann erfolgt der Fortgang in den Startzustand und das Warten auf ein weiteres Ereignis, bis am Ende der vorher eingestellten Zeit die Rückstellung erfolgt, und wenn an dem Ende der vorher eingestellten Zeit bis zu drei Übergangsereignisse angezeigt worden sind, dann erfolgt der Bericht als intermittierender Fehler, Alarm und Rückstellung.

2. Verfahren nach Anspruch 1, **dadurch gekennzeichnet, daß** der Übergangsrichtungs-Erfassungsschritt und der zufällige intermittierende Erfassungsschritt die folgenden Zustände aufweist: einen einsatzbereiten Zustand, sobald der Algorithmus die Überwachung unterhält und startbereit ist; einen Startzustand, sobald der Algorithmus die Fehlerbewertung beginnt; und einen Alarm- / Rückstell-Zustand, der dann auftritt, wenn der Startzustand endet, wobei das Ergebnis durch Alarm oder Rückstellung angezeigt wird.

3. Verfahren nach Anspruch 2, **dadurch gekennzeichnet, daß** dann, wenn ein Übergangsereignis durch zufällige intermittierende Ermittlung von die Übergangsrichtungs-Ermittlung am Ende des Startzustandes festgestellt werden, weitere Ereignisse erwartet werden, und wenn aufeinanderfolgende drei Übergangsereignisse in einer Rückstell-Zeitdauer ermittelt werden, ein intermittierender Erdfehler berichtet wird.

4. Verfahren nach Anspruch 1, **dadurch gekennzeichnet, daß** das augenblickliche aktive oder reaktive Leistung für die Richtungsermittlung benutzt wird.

5. Verfahren nach Anspruch 1, **dadurch gekennzeichnet, daß** Fehlerkomponenten des Reststroms oder der Restspannung zur Berechnung der augenblicklichen Leistung benutzt werden.

6. Verfahren nach Anspruch 5, **dadurch gekennzeichnet, daß** die Hilbert-Transformation auf der Grundlage der augenblicklichen Leistung benutzt wird.

7. Verfahren nach Anspruch 6, **dadurch gekennzeichnet, daß** die augenblickliche aktive Leistung mittels Durchschnittsbildung der momentanen Restspannung und der restlichen Strom-Skalar-Multiplikation in dem vorherigen Zyklus-Zeitfenster erhalten wird, während die augenblickliche reaktive Leistung durch Durchschnittsbildung der Hilbert-transformierten momentanen Restspannung und der restlichen Strom-Skalar-Multiplikation in dem vorhergehenden Zyklus-Zeitfenster erhalten wird, wobei die Richtungsunterscheidung durch Vergleichen der solchermaßen momentanen aktiven Leistung oder solchermaßen momentanen reaktiven Leistung mit einem Leistungsschwellenwert vorgenommen wird.

8. Verfahren nach Anspruch 5, **dadurch gekennzeichnet, daß** das Sammeln und Speichern der Abtastwerte des Reststroms und der Restspannung in dem normalen Laufzustand (einsatzbereiter Zustand) aufrechterhalten wird, und daß diese normalen Abtastwerte in dem Fehlerbewertungszustand (Startzustand) gehalten werden, wobei die Fehlerkomponente durch Subtraktion dieser normalen Abtastwerte von den vollen Abtastwerten im Startzustand erfaßt werden und die Fehlerkomponente zur momentanen Leistungsberechnung und zur weiteren Richtungsermittlung benutzt werden.

9. Verfahren nach Anspruch 5, **dadurch gekennzeichnet, daß** in dem Fehlerkomponentenkreis, wenn angenommen wird, daß die Richtung von der Stromschiene zu der Zufuhrleitung die positive / Vorwärts-Richtung ist, ein Stromschwellenwert vorbestimmt wird.

10. Verfahren nach Anspruch 9, **dadurch gekennzeichnet, daß** dann, wenn die aktive, augenblickliche Leistung negativ ist und unter den negativen Wert eines Leistungsschwellenwertes fällt, eine Vorwärts-Richtung eingeschlagen wird, wenn die aktive augenblickliche Leistung positiv und größer ist als der positive Wert des aktiven Leistungsschwellenwertes, so daß dann eine Umkehrrichtung eingeschlagen wird.

11. Verfahren nach Anspruch 9, **dadurch gekennzeichnet, daß** dann, wenn die reaktive, augenblickliche Leistung positiv und größer ist als der positive, reaktive Leistungsschwellenwert, ein Vorwärts-Richtungsergebnis ausgegeben wird; und wenn die reaktive, augenblickliche Leistung negativ ist und unter dem negativen Wert des reaktiven Leistungsschwellenwertes liegt, dann ein Umkehrrichtungs-Ergebnis ausgegeben wird.

12. Verfahren nach Anspruch 9, **gekennzeichnet durch** einen Fehlerbewertungs-Schritt, wobei die Richtung **durch** Vergleichen der berechneten augenblicklichen Leistung mit einem Leistungsschwellenwert erhalten wird und der Leistungsschwellenwert sich adaptiv gemäß dem Maximalwert der berechneten Leistung ändert.

13. Verfahren nach Anspruch 12, **dadurch gekennzeichnet, daß** der Leistungsschwellenwert auf die Hälfte des maximalen berechneten absoluten Leitungswertes eingestellt wird.

14. Verfahren nach Anspruch 13, **dadurch gekennzeichnet, daß** dann, wenn der augenblickliche Leistungswert derart ist, daß sein absoluter Wert fünfmal größer ist als die gegenwärtigen aktiven oder reaktiven Leistungsschwellenwerte, die Hälfte des größten augenblicklichen absoluten Leistungswertes als neuer Schwellenwert betrachtet wird.

15. Verfahren nach Anspruch 1, **dadurch gekennzeichnet, daß** zur Ermittlung intermittierender Spitzen eine inkrementale Amplitude verwendet wird, und daß zum Start der Fehlerbewertung die Amplitude unter Verwendung der Halbkreis-R.M.S.-Rechnung berechnet wird.

16. Verfahren nach Anspruch 15, **dadurch gekennzeichnet, daß** die Spitzenrichtung von dem Übergangsrichtung-Erfassungsschritt erhalten wird, sobald die Fehlerbewertung innerhalb einer einstellbaren Ermittlungszeit gestattet wird, wobei die Spitzen mit Vorwärtsrichtung gezählt werden und die Ergebnisse am Ende der Fehlerbewertungszeit dazu benutzt werden, die speziellen Schwellenwerte zu vergleichen.

17. Verfahren nach Anspruch 15, **dadurch gekennzeichnet, daß** die inkrementale Amplitude durch Subtrahieren der Durchschnittsamplitude von der neuberechneten Amplitude erhalten wird, daß die Durchschnittsamplitude durch einen Filter: $y(n) = [y(n-1) \times (N-1) + x(n)] / N$, wobei $y(n)$ die Durchschnittsamplitude zu einem Stromzeitpunkt ist, erhalten wird und die vorherigen N-Punkt-Amplituden-Bedingungen repräsentiert, wobei $y(n-1)$ die Durchschnittsamplitude des vorherigen Punktes und $x(n)$ die neuberechnete Amplitude sind.

18. Verfahren nach Anspruch 15, **dadurch gekennzeichnet, daß** am Ende der Fehlerbewertung, wenn die Anzahl der gezählten Spitzen ein bestimmtes Niveau überschreitet, das Ergebnis einen intermittierenden Fehler anzeigt; wenn die Anzahl der Spitzen größer als 2 ist, jedoch unter der vorbestimmten Höhe liegt, ein Übergangsereignis berichtet wird; wenn die Amplitude weiter ansteigt oder unverändert bleibt, ohne abzunehmen, ein stetiges Ereignis das Ergebnis ist; und andere Situationen als Geräusche berichtet werden.

19. System zur transienten und intermittierenden Erdfehlererfassung und Richtungsbestimmung in einem elektrischen, dreiphasigen Mittelspannungs-Leistungsteilungssystem, das viele Leitungen aufweist, **gekennzeichnet durch** folgende Merkmale: eine Abtasteinrichtung (20), die in der Lage ist, Reststrom und Restspannung in einer der genannten Leitungen abzutasten, die Leistungsfrequenz zuführen und die Abtastrate auf exakt N Punkte pro Zyklus einzustellen, wobei N ganzzahlig ist; ferner umfassend eine Übergangsrichtung-Erfassungseinrichtung (24), die sich **kennzeichnet durch** in einem einsatzbereiten Zustand eine Aktualisierung von Abtastwerten des Reststroms und der Restspannung in einem Puffer; in einem Startzustand die Berechnung des überlagerten Reststroms und der Restspannung **durch** Subtraktion eines Punktes in dem Puffer von dem neu korrespondierenden, abgetasteten Reststrom und Restspannung, ferner **durch** Berechnen der augenblicklichen Leistungsrichtung auf der Grundlage des überlagerten Reststroms und der Restspannung, des weiteren **durch** Ausgabe eines Richtungsergebnisses **durch** Vergleichen der berechneten augenblicklichen Spannung mit einem Leistungsgrenzwert, des weiteren umfassend eine zufällige, intermittierende Ermittlungseinrichtung (22), die folgendes aufweist: in einem einsatzbereiten Zustand Speichern eines durchschnittlichen Amplitudenwertes, Berechnen einer inkrementalen Amplitude **durch** Subtraktion des Durchschnittswertes von der vollen Amplitude; des weiteren in einem Startzustand Vergleichen der inkrementalen Amplitude mit einem gesprengten Schwellenwert, wobei ein Fehler angenommenermaßen mitgeführt wird, wenn die inkrementale Amplitude größer ist als der gesprengte Schwellenwert; ferner umfassend eine Einrichtung zur Integration der Übergangsrichtungs-Ermittlung und der zufälligen intermittierenden Ermittlung, aufweisend folgende Merkmale: Starten eines Zählers (25) und Zählen der Anzahl aufeinanderfolgender leitender und auslöschender, formender Spitzen, wobei nur die Spitzen mit Vorwärtsrichtung gezählt werden, die sich aus der Übergangs-Richtungsermittlungseinrichtung ergeben, Vergleichen des Fehlerwertes, der am Ende einer vorgegebenen Zeit erhalten wird, mit vielen Schwellenwerten, so daß ein Ergebnis erzielt wird, also ein intermittierender Fehler, ein Übergangsereignis oder ein stetiges Ereignis; des weiteren eine Einrichtung (26) zur Ausgabe des Ergebnisses **durch** Alarm oder Rückstellung; wobei dann, wenn das Ergebnis ein intermittierender Fehler ist, Bericht und Alarm und Rückstellung erfolgen und dann, wenn das Ergebnis Geräusche oder ein stetiges Ereignis sind, es nicht zur Kenntnis genommen und nichts getan wird, und dann, wenn das Ergebnis ein Übergangsereignis ist, Fortsetzung in den Startzustand und Warten auf ein weiteres Ereignis erfolgen, bis **durch** einen vorher eingestellten Zeitgeber Rückstellung bewirkt wird, und wenn am Ende der vorher eingestellten Zeit bis zu drei Übergangsereignisse angegeben worden sind, dieses Ereignis als intermittierender Fehler, Alarm und Rückstellung berichtet wird.

20. System nach Anspruch 19, umfassend die folgenden Merkmale: einen Modul (20) zum Abtasten von Spannung und Strom, einen Trigger (21), ein intermittierendes Spitzenermittlungsmodul (22), ein Modul (23) zur Einstellung eines Leistungsschwellenwertes der Übergangsrichtungsermittlung, ein momentanes Leistungsrichtungsmodul (24), einen Zähler (25) und ein Modul (26) zur Ausgabe eines Berichtes.

**Revendications**

1. Procédé pour la détection et la détermination de direction de défaut de terre transitoire et intermittent dans un système de distribution de puissance électrique de tension médiane triphasée qui comprend de nombreuses lignes, **caractérisé en ce qu'**il comprend, pour une ligne :

   - une étape d'échantillonnage dans laquelle le courant résiduel et la tension résiduelle sur ladite ligne sont échantillonnés, la fréquence de puissance est suivie et la fréquence d'échantillonnage est ajustée à N points par cycle, N étant un entier,
   - une étape de détection de direction transitoire comprenant :

      . dans une étape « prêt »,
      * la mise à jour des échantillons du courant résiduel et de la tension résiduelle dans une mémoire tampon,
      . dans une étape de démarrage,
      * le calcul du courant résiduel et de la tension résiduelle superposés en soustrayant un point dans la mémoire tampon du courant résiduel et de la tension résiduelle nouvellement échantillonnés correspondants,
      * le calcul de la direction de la puissance instantanée sur la base du courant résiduel et de la tension résiduelle superposés,
      * l'obtention d'un résultat de direction en comparant la puissance instantanée calculée à un seuil de puissance,

   - une étape de détection intermittente aléatoire comprenant :

      . dans une étape « prêt »,
      * l'accumulation d'une valeur d'amplitude moyenne, * le calcul d'une amplitude incrémentale en soustrayant la valeur moyenne de l'amplitude totale,
      . dans une étape de démarrage,
      * la comparaison de l'amplitude incrémentale à un seuil de salve, un défaut étant supposé exister si l'amplitude incrémentale est supérieure au seuil de salve,

   - une étape d'intégration d'une détection de direction transitoire et d'une détection intermittente aléatoire comprenant :

      * le comptage du nombre de conductions et d'extinctions consécutives, formant des pointes, en comptant uniquement les pointes avec un résultat de direction directe de l'étape de détection de direction transitoire pour l'évaluation de défaut,
      * la comparaison de la valeur comptée obtenue à la fin d'un temps présélectionné à de nombreux seuils de sorte qu'un résultat soit obtenu : c'est un défaut intermittent, un événement transitoire ou un événement permanent,

- une étape de communication du résultat par une alarme ou une réinitialisation de la manière suivante :

&ast; si le résultat est un défaut intermittent, alors rapporter et alerter et réinitialiser,
&ast; si le résultat consiste en des bruits ou un événement permanent, alors ignorer, ne rien faire,
&ast; si le résultat est un événement transitoire, poursuivre à l'étape de démarrage et attendre un autre événement jusqu'à une réinitialisation à la fin du temps présélectionné,
&ast; si, à la fin du temps présélectionné, jusqu'à trois événements transitoires ont été repérés, alors rapporter en tant que défaut intermittent, alerter et réinitialiser.

2. Procédé selon la revendication 1, dans lequel l'étape de détection de direction transitoire et l'étape de détection intermittente aléatoire comportent les étapes suivantes :

- une étape « prêt », lorsque l'algorithme maintient une surveillance et est prêt à être démarré ;
- une étape de démarrage lorsque l'algorithme commence à évaluer le défaut ; et
- une étape d'alerte/réinitialisation, se produisant lorsque l'étape de démarrage se termine, dans laquelle le résultat est communiqué par alerte ou réinitialisation.

3. Procédé selon la revendication 2, dans lequel, si un événement transitoire est détecté par une détection intermittente aléatoire et une détection de direction transitoire à la fin de l'étape de démarrage, d'autres événements sont attendus, et si trois événements transitoires consécutifs sont détectés dans les limites d'une durée d'un temps de réinitialisation, un défaut de terre intermittent est rapporté.

4. Procédé selon la revendication 1, dans lequel la puissance active ou réactive instantanée est utilisée pour la détection de direction.

5. Procédé selon la revendication 1, dans lequel les composantes de défaut de courant résiduel et de tension résiduelle sont utilisées pour calculer la puissance instantanée.

6. Procédé selon la revendication 5, dans lequel la puissance instantanée basée sur une transformation de Hilbert est utilisée.

7. Procédé selon la revendication 6, dans lequel la puissance active instantanée est obtenue en moyennant la multiplication scalaire de la tension résiduelle et du courant résiduel instantanés dans une fenêtre temporelle d'un cycle précédent, tandis que la puissance réactive instantanée est obtenue en moyennant la multiplication scalaire de la tension résiduelle et du courant résiduel instantanés transformée par transformation de Hilbert dans une fenêtre temporelle d'un cycle précédent, la discrimination de direction étant effectuée en comparant cette puissance active instantanée ou cette puissance réactive instantanée à un seuil de puissance.

8. Procédé selon la revendication 5, qui maintient l'échantillonnage et la mise en mémoire tampon des échantillons du courant résiduel et de la tension résiduelle dans l'étape de fonctionnement normal (étape « prêt »), et ces échantillons normaux seront conservés dans l'étape d'évaluation de défaut (étape de démarrage), la composante de défaut étant obtenue en soustrayant ces échantillons normaux des échantillons totaux dans l'étape de démarrage et les composantes de défaut étant utilisées pour le calcul de puissance instantanée et en outre la détection de direction.

9. Procédé selon la revendication 5, dans lequel, dans le circuit de composante de défaut, en supposant que la direction de la barre omnibus au dispositif d'alimentation est la direction positive/directe, un seuil de puissance est prédéterminé.

10. Procédé selon la revendication 9, dans lequel, si la puissance instantanée active est négative et tombe au-dessous de la valeur négative d'un seuil de puissance, une direction directe est alors émise ; si la puissance instantanée active est positive et est supérieure à la valeur positive du seuil de puissance active, une direction inverse est alors émise.

11. Procédé selon la revendication 9, dans lequel, si la puissance instantanée réactive est positive et supérieure au seuil de puissance réactive positive, un résultat de direction directe est alors émis ; si la puissance instantanée réactive est négative et inférieure à la valeur négative du seuil de puissance réactive, alors un résultat de direction inverse est émis.

**12.** Procédé selon la revendication 9, comprenant une étape d'évaluation de défaut, dans lequel la direction est donnée en comparant la puissance instantanée calculée avec un seuil de puissance, le seuil de puissance changeant de manière adaptative en fonction de la valeur maximum de la puissance calculée.

**13.** Procédé selon la revendication 12, dans lequel le seuil de puissance est fixé à une moitié de la valeur absolue de la puissance calculée maximum.

**14.** Procédé selon la revendication 13, dans lequel, si la valeur de puissance instantanée est telle que sa valeur absolue est cinq fois supérieure aux seuils actuels de puissance active ou de puissance réactive, la moitié de la valeur absolue de la puissance instantanée la plus grande est considérée comme étant le nouveau seuil.

**15.** Procédé selon la revendication 1, dans lequel une amplitude incrémentale est utilisée pour détecter des pointes intermittentes, et pour lancer une évaluation de défaut, l'amplitude étant calculée en utilisant un calcul de valeur efficace de demi-cycle.

**16.** Procédé selon la revendication 15, dans lequel la direction de la pointe est obtenue à une étape de détection de direction transitoire, lorsqu'une évaluation de défaut est lancée dans la limite d'un temps de détection configurable, lesdites pointes avec une direction directe étant comptées, les résultats à la fin du temps d'évaluation de défaut étant utilisés pour une comparaison à des seuils spécifiés.

**17.** Procédé selon la revendication 15, dans lequel l'amplitude incrémentale est obtenue en soustrayant l'amplitude moyenne de l'amplitude nouvellement calculée, l'amplitude moyenne étant obtenue par un filtre : $y(n) = [y(n-1) . (N-1) + x(n)]/N$, où $y(n)$ est l'amplitude moyenne à un instant actuel, et représente des conditions d'amplitude de N points précédents, $y(n-1)$ est l'amplitude moyenne du point précédent, $x(n)$ est l'amplitude nouvellement calculée.

**18.** Procédé selon la revendication 15, dans lequel, à la fin d'une évaluation de défaut, si le nombre de pointes comptées dépasse un niveau déterminé, le résultat indique un défaut intermittent ; si le nombre de pointes est supérieur à 2, mais est inférieur au niveau déterminé, un événement transitoire est rapporté ; si l'amplitude reste croissante ou reste inchangée sans diminution, un événement permanent est obtenu en tant que résultat ; les autres situations étant rapportées en tant que bruits.

**19.** Système pour la détection et la détermination de direction de défaut de terre transitoire et intermittent dans un système de distribution de puissance électrique de tension médiane triphasée qui comprend de nombreuses lignes, **caractérisé en ce qu'**il comprend :

- des moyens d'échantillonnage (20) conçus pour échantillonner un courant résiduel et une tension résiduelle sur l'une desdites lignes pour suivre la fréquence de puissance et pour ajuster la fréquence d'échantillonnage exactement à N points par cycle, N étant un entier,
- des moyens de détection de direction transitoire (24), qui effectuent :

. dans une étape « prêt »,
* la mise à jour des échantillons du courant résiduel et de la tension résiduelle dans une mémoire tampon,
. dans une étape de démarrage,
* le calcul du courant résiduel et de la tension résiduelle superposés en soustrayant un point dans la mémoire tampon du courant résiduel et de la tension résiduelle nouvellement échantillonnés correspondants,
* le calcul de la direction de la puissance instantanée sur la base du courant résiduel et de la tension résiduelle superposés,
* l'obtention d'un résultat de direction en comparant la puissance instantanée calculée à un seuil de puissance,

- des moyens de détection intermittente aléatoire (22), qui effectuent :

. dans une étape « prêt »,
* l'accumulation d'une valeur d'amplitude moyenne,

* le calcul d'une amplitude incrémentale en soustrayant la valeur moyenne de l'amplitude totale,
. dans une étape de démarrage,
* la comparaison de l'amplitude incrémentale à un seuil de salve, un défaut étant supposé exister si l'amplitude incrémentale est supérieure au seuil de salve,

- des moyens d'intégration d'une détection de direction transitoire et d'une détection intermittente aléatoire, qui effectuent :

* le démarrage d'un compteur (25) et le comptage du nombre de conductions et d'extinctions consécutives, formant des pointes, en comptant uniquement les pointes avec un résultat de direction directe par les moyens de détection de direction transitoire,
* la comparaison de la valeur du compteur obtenue à la fin d'un temps présélectionné avec de nombreux seuils de sorte qu'un résultat soit obtenu : c'est un défaut intermittent, un événement transitoire ou un événement permanent,

- des moyens (26) pour communiquer le résultat par une alerte ou une réinitialisation pour :

* si le résultat est un défaut intermittent, alors rapporter et alerter et réinitialiser,
* si le résultat consiste en des bruits ou un événement permanent, alors ignorer, ne rien faire,
* si le résultat est un événement transitoire, alors poursuivre à l'étape de démarrage et attendre un autre événement jusqu'à une réinitialisation par un registre d'horloge présélectionné,
* si, à la fin du temps présélectionné, jusqu'à trois événements transitoires ont été repérés, alors rapporter en tant que défaut intermittent, alerter et réinitialiser.

**20.** Système selon la revendication 19, qui comprend :

- un module (20) pour échantillonner une tension et un courant,
- un déclencheur (21),
- un module de détection de pointe intermittente (22),
- un module (23) pour ajuster un seuil de puissance de détection de direction transitoire,
- un module de direction de puissance instantanée (24),
- un compteur (25),
- un module (26) communiquant un rapport.

Reverse | Forward

$IN_H$ — 13

11 — 10

Reverse | Forward

$IN_F$ — 13

16 — 10

$R_N$

VN 14 12

R

15 $S_{FT}$

$R_E$

**FIG.1**

21 22

Trigger start → Intermittent Spike detection RID

20 25 26

Sampling Voltage and current

Counter → Report

**FIG.2**

Adjust threshold → Instantaneous power direction TDD

23 24

**FIG.3**

Instantaneous
Reactive Power

Forward                    Reverse

Instantaneous
Active Power

0

-P Threshold
(Forward Direction)

-Noise Threshold

+Noise Threshold

+P Threshold
(Reverse Direction)

## FIG.4A

Instantaneous
Reactive Power

+Q Threshold
(Forward Direction)                    Forward

+Noise Threshold

Instantaneous
Active Power

0

-Noise Threshold

-Q Threshold
(Reverse Direction)                    Reverse

## FIG.4B

Instantaneous
Reactive Power

Forward

>5
(6)

3

+Q Threshold
(Forward Direction)                    2

1

+Noise Threshold

Time

0

-Noise Threshold

-Q Threshold
(Reverse Direction)                    -1

Reverse                    -3

## FIG.5

START

FIG.6

**FIG.7A**

**FIG.7B**

**FIG.7C**

FIG.8A

FIG.8B

FIG.8C

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20080031520 A
- US 5485093 A
- WO 2005038474 A
- EP 0999633 A